# EUROPÄISCHE PATENTANMELDUNG

(11) **EP 1 258 924 A2**
(43) Veröffentlichungstag der Anmeldung: **20.11.2002**
(21) Anmeldenummer: 02010017.8
(22) Anmeldetag: 04.05.2002
(51) Int. Cl.: H01L 27/12, H01L 21/84

(54) **Verfahren zur Herstellung von Bauelementen auf einem SOI-Wafer**

(30) Priorität: 16.05.2001 DE 10124032
(71) Anmelder: ATMEL Germany GmbH, 74072 Heilbronn (DE)
(72) Erfinder: Dietrich, Harry, 74912 Kirchardt (DE); Dudek, Volker, Dr., 74336 Brackenheim (DE); Schüppen, Andreras, Dr., 74348 Lauffen (DE)
(74) Vertreter: Kolb, Georg

(57) **Zusammenfassung**

2.1 Bei den bisher bekannten Verfahren, behindern die unterschiedlichen elektrischen Anforderungen von den MOS- bzw. den Bipolar-Transistoren an die Dicke der auf der isolierenden Zwischenschicht aufliegenden Siliziumschicht, die Integration der unterschiedlichen Gattungen von Bauelementen auf einem Wafer.
2.2 Nach dem neuen Verfahren werden die Anforderungen an die Dicke insbesondere der Bipolar-Transistoren durch das Einbringen von vergrabenen silizidierten Bereichen wesentlich reduziert, da die bisherige "buried -layer" Schicht durch eine dünne niederohmige Silizidschicht ersetzt wird. Ferner lassen sich die HF-Eigenschaften der MOS-Transistoren durch die vergrabenen Silizidbereiche verbessern.

## Beschreibung

Die vorliegende Erfindung betrifft ein Verfahren zur Herstellung von Bauelementen auf einem Silizium-Wafer, gemäß dem Oberbegriff des Patentanspruchs 1.

Ein derartiges Verfahren ist aus der Druckschrift US 5 583 059 bekannt. Darin wird die Integration von einem sogenannten "fully depleted" n- und p-Fet in Verbindung mit einem NPN-Heterobipolar Transistor (HBT) auf einem Wafer mit einer isolierenden Zwischenschicht (SOI-Wafer), der eine aktive Schichtdicke kleiner als 0.2 µm aufweist, beschrieben. Zur Isolierung der einzelnen Bauelemente und Reduzierung der parasitären Kapazitäten wird die Siliziumschicht um die aktiven Bauelemente vollständig entfernt. Ferner wird zur Ausbildung einer Kollektorschicht für die Herstellung eines NPN-Transistors die Dicke der aktiven Schicht im Bereich der NPN-Transistors mittels eines Epitaxieprozesses erhöht. Sofern kein selektiver Epitaxieprozess durchgeführt wird, werden zum Schutz der FET-Bauelemente Schutzschichten aufgebracht, die in nachfolgenden Prozessschritten wieder entfernt werden. Während des mehrstufigen Epitaxieprozesses wird ebenfalls die Basis des HBTs abgeschieden, wobei ein sogenannter Drift-HBT erzeugt wird, der keine niedrigdotierte Emitterschicht zwischen Emitteranschlußschicht und Basisschicht aufweist.
Nachteilig an der beschriebenen Prozeßarchitektur ist, daß die Schichtdicke der aktiven Schicht im Bereich der NPN-Transistoren wesentlich erhöht werden muß, um elektrische Parameter wie Earlyspannung und Kollektorbahnwiderstand einzustellen. Hierzu muß die Kollektoranschlußschicht (buried layer) eine Dicke aufweisen, die in der Größenordnung der Ausgangsdicke der aktiven Siliziumschicht liegt, wobei es mit vertretbarem Aufwand nicht möglich ist, die Dotierung der Kollektoranschlußschicht in den Bereich von 10 e17 cm3 zu erhöhen, da unter anderem eine Aktivierung dieser Konzentration zu einer starken Ausdiffusion führt.

Ein weiteres Verfahren zur Herstellung eines Bauelementes auf einem SOI-Wafer ist aus der Druckschrift S.B. Goody, et al, "High Speed Bipolar on S²O|" in, ESSDERC 1998 bekannt.

Darin wird die Herstellung eines NPN-Transistors beschrieben, der eine vergrabene silizidierte Kollektoranschlussschicht aufweist. Hierzu wird auf einem ersten Silizium-Wafer, der eine ganzflächige Oxidschicht aufweist, auf der Oberfläche der Oxidschicht eine ganzflächige Silizidschicht gebildet. Anschließend wird mittels Waferbonding ein SOI-Wafer mit einer ganzflächigen vergrabenen Silizidschicht hergestellt, indem auf die Silizidschicht die Oberfläche eines zweiten Silizium-Wafers gebonded wird. Anschließend wird der zweite Silizium-Wafer auf die gewünschte Dicke gedünnt, um in der verbleibenden Siliziumschicht NPN-Transistoren herzustellen.
Nachteilig bei der beschriebenen Prozessarchitektur ist, daß sich dieses Verfahren nicht mit vertretbarem Aufwand auf die Integration mit MOS-Transistoren erweitern lässt, da eine ganzflächige Silizidschicht die elektrischen Eigenschaften durch die Erhöhung der parasitären Verkopplungen, wie beispielsweise die Verzögerungszeit, wesentlich verschlechtert. Ferner ist es schwierig die Oberfläche der ganzflächigen Silizidschicht mit der Oberfläche eines weiteren Wafers fest und versetzungsfrei zusammenzufügen.

Ferner ist in der Druckschrift DE 196 09 933 die Prozeßarchitektur für einen NPN-HBT für einen Siliziumwafer ohne isolierende Zwischenschicht beschrieben, wobei die Stromverstärkung durch die Erzeugung einer epitaktischen relativ niedrigdotierten Emitterschicht, die das Tunneln der Minoritäten in den Emitter unterdrückt, erhöht wird. Ferner wird mit einer relativ dicken hochdotierten Kollektoranschlussschicht (buried layer) der den Anschlusswiderstand des Kollektors reduziert und der Justierung der Kollektordicke und der Dotierung, Grenzfrequenzen oberhalb 50 GHz bei relativ niedrigen Kollektorströmen erreicht. Des Weiteren wird mittels einer sogenannten "Inside- Outside Spacer" -Technik und die Vermeidung von Trokkenätzprozessen auf dem Emitterfenstern eine hohe Reproduzierbarkeit der elektrischen Parameter im Herstellungsprozess erreicht.
Nachteilig ist, daß in dem ausschließlich auf die Herstellung von bipolaren Transistoren ausgerichteten Herstellungsprozeß sich nur mit großem Aufwand MOS-Transistoren integrieren lassen. Ferner wird durch die Verwendung eines herkömmlichen Silizium-Wafers, die weitere Verbesserung der HF-Eigenschaften behindert, da parasitäre Verkopplungen mit dem Substrat auftreten.

Ein Ziel der Entwicklungen im Gebiet der Halbleitertechnologie ist es, Verfahren zu entwikkeln, mit denen sich bipolare bzw. HBT-Transistoren für Höchstfrequenzanwendungen mit solchen FET-Transistoren, die extrem kurze Verzögerungszeiten aufweisen, ohne Abstriche an den elektrischen Eigenschaften der jeweiligen Gattung kombinieren lassen. Dies erfordert einerseits beispielsweise für die MOS-Transistoren sehr dünne aktive Siliziumschichten mit einer Dicke im Bereich von 0.2 µm und kleiner, während andererseits für die bipolaren Transistoren dicke Siliziumschichten oberhalb 0.4 µm benötigt werden. Ferner müssen die parasitaren Verkopplungen zum Substrat weitestgehend unterdrückt werden. Ein wichtiges Anwendungsgebiet für derartige Kombinationen von unterschiedlichen Gattungen von Bauelementen ist die Herstellung von hochintegrierten Schaltungen, die neben einer sehr schnellen digitalen Signalverarbeitung auch HF-Leistungen bei höchsten Frequenzen zur Verfügung stellt.
Aufgabe der vorliegenden Erfindung ist es, ein Verfahren der Eingangs genannten Art anzugeben, mit dem sich unterschiedliche Gattungen von Bauelementen für hohe Frequenzen gemeinsam auf einem Wafer mit vertretbarem Aufwand herstellen lassen.

Die erstgenannte Aufgabe wird durch die Merkmale des Patentanspruches 1 gelöst. Günstige Ausgestaltungsformen sind Gegenstand von Unteransprüchen.

Hiernach besteht das Wesen der Erfindung darin, daß durch das Zusammenfügen von zwei Wafern ein neuer Wafer hergestellt wird, der vergrabene silizidierte Bereiche und eine isolierende Zwischenschicht aufweist, und in der obersten Siliziumschicht Bauelemente unterschiedlicher Gattungen, wie beispielsweise bipolare Transistoren als auch FET-Transistoren mit jeweils optimierten HF-Parametern auf einem Wafer integriert werden. Hierzu wird auf einem Silizium-Wafer bestehend, aus einem ersten aus einer auf einem Träger angeordneten isolierenden Zwischenschicht und einer sich daran anschließenden Oberflächenschicht, und einem zweiten eine Oberfläche aufweisenden Silizium-Wafer, ein Wafer mit einer isolierenden Zwischenschicht erzeugt, indem die beiden Wafer über die jeweiligen Oberfläche zusammengefügt werden (bonden) und vor dem Zusammenfügen auf dem ersten Silizium-Wafer innerhalb oder auf der Oberfläche der Oberflächenschicht wenigstens ein silizidierter Bereich erzeugt wird, und anschließend auf der Oberfläche wenigstens eines Silizium-Wafers wenigstens eine isolierende Schicht aufgebracht wird, und nach dem Zusammenfügen der Träger und wenigstens ein Teil der isolierenden Schicht des ersten Silizium-Wafers entfernt wird und anschließend in einer Abfolge von mehreren Prozessschritten wenigstens ein Bauelement hergestellt wird.
Untersuchungen der Anmelderin haben gezeigt, daß es für die Herstellung von Bauelementen für hohe Frequenzen vorteilhaft ist, die Dicke der Oberflächenschicht klein, vorzugsweise unterhalb 1.0 µm, zu wählen. Ferner ist es vorteilhaft, bei der Herstellung der Silizid-Bereiche die umgebenden Gebiete mittels einer Oxidmaske zu schützen und durch weitere Prozeßschritte, wie beispielsweise mit einer Siliziumätzung, die silizidierten Bereiche in unterschiedlichen Tiefen zu erzeugen.

Ein Vorteil des neuen Verfahrens gegenüber dem bisherigen Stand der Technik ist, daß vor dem Zusammenfügen auf dem ersten Wafer nur die Bereiche silizidiert werden, in denen das Einfügen einer Silizidschicht die elektrischen Eigenschaften der Bauelemente, die in einem nach dem Zusammenfügen folgenden Herstellungsprozeß erzeugt werden, verbessert. Durch das Zusammenfügen der beiden Wafer werden die silizidierten Bereiche vergraben, wobei die Bereiche in unterschiedlichen Tiefen innerhalb der Oberflächenschicht liegen. Mittels der vergrabenen Silizidbereiche lassen sich insbesondere die "buried layer"-Schichten ersetzen, die als Anschlußschichten für Bauelemente dienen. Da die Leitfähigkeit von Siliziden wesentlich größer als die von dotiertem Silizium ist, läßt sich die Dicke der obersten Siliziumschicht und oder die Anschlußwiderstände der Bauelemente verringern. Unterschiede in der Dicke der Oberflächenschicht, die die unterschiedlichen Gattungen von Bauelementen erfordern, werden wesentlich verkleinert. Ferner verbessern sich die elektrischen und insbesondere die HF-Eigenschaften von vertikal aufgebauten Bauelementen.

In einer Weiterbildung des Verfahrens ist es vorteilhaft, die isolierende Zwischenschicht, die vorzugsweise eine Dicke oberhalb 0.2 µm aufweist, mittels einer Abscheidung zu erzeugen und ausschließlich auf der Oberfläche des ersten Wafers aufzubringen, da sich damit vor dem Zusammenfügen die Prozessierung des zweiten Wafers erübrigt. Ferner ist es vorteilhaft, daß die isolierende Zwischenschicht gebietsweise eine unterschiedliche Dicke aufweist, wobei insbesondere die Bereiche eine höhere Dicke aufweisen, in denen die in der Oberflächenschicht hergestellten Bauelemente eine besonders hohe Entkopplung zu dem unterliegenden Trägermaterial erfordern.

In einer anderen Weiterbildung des Verfahrens wird die Dicke der Oberflächenschicht vor oder nach dem Zusammenfügen bereichsweise verändert um diese an die unterschiedlichen Erfordernissen der elektrischen Parameter der einzelnen Gattungen der Bauelemente anzupassen. Hierzu wird ausgehend von einer sehr dünnen Siliziumschicht, die beispielsweise unter 0.2 µm liegt, mittels eines Epitaxieprozesses die Dicke der Oberflächenschicht gebietsweise mittels selektiver Epitaxie erhöht, oder ausgehend von einer dicken Oberflächenschicht, die beispielsweise im Bereich von 1.0 µm liegt, die Schichtdicke mittels der Erzeugung eines thermischen Oxid, beispielsweise mit einer sogenannten LOCOS-Oxidation, gebietsweise verringert. In Verbindung mit dem Ersetzen der "buried layer" Bereiche durch Slizide läßt sich die Dicke der Oberflächenschicht an die elektrischen Parameter der einzelnen Bauelementgattungen, die nach dem Zusammenfügen hergestellt werden, vorteilhaft anpassen.

In einer Weiterbildung des Verfahrens wird als ein gattungsbildendes Bauelement ein MOS-Transistor erzeugt. Hierbei ist es vorteilhaft, wenn die Dicke der Oberflächenschicht sehr dünn ist und die Source- und Drain-Zonen des NMOS oder des PMOS die Oberflächenschicht des ersten Silizium-Wafers vollständig durchdringen (fully depleted), da derartige Transistoren besonders kurze Verzögerungszeiten bzw. Schaltzeiten aufweisen. Um die HF-Eigenschaften, wie beispielsweise die Schaltzeit des Transistors zu verbessern, läßt sich mitteis einer vergrabenen silizidierten Schicht den Source-Bereich mit dem Body-Bereich des Transistors kurzschließen.

In einer anderen Weiterbildung des Verfahrens, wird als ein gattungsbildendes Element ein bipolarer Transistor, der vorzugsweise einen vertikalen Aufbau besitzt, hergestellt. Dabei lassen sich sowohl Transistoren vom Typ PNP als auch vom TYP NPN erzeugen. Hierbei werden die Transistoren in den Gebieten der Oberflächenschicht hergestellt, die im Vergleich zu den Gebieten mit den MOS-Transistoren, eine vergleichsweise große Dicke der Oberflächenschicht aufweisen. Der Kollektoranschluß der Transistoren erfolgt mittels eines vergrabenen silizidierten Bereichs, um die Sättigungsspannungen der Transistoren zu erniedrigen. Ferner verringert sich durch die Reduzierung des Kollektorbahnwiderstandes der Spannungsabfall bei kleinen Spannungen im Transistors, womit das Maximum der Grenzfrequenz bei geringeren Kollektorstömen erreicht wird und sich mit HF-Transistoren bei kleinen Spannungen große HF-Leistungen erzielen lassen, wobei es für Höchstfrequenzanwendungen besonders vorteilhaft ist, einen HBT-Transistor zu integrieren.

In einer Weiterbildung des Verfahrens wird als ein gattungsbildendes Bauelement ein Kondensator hergestellt, wobei in vorteilhafter Weise ein vergrabener Silizidbereich als erste Kondensatorplatte verwendet wird. Als dielektrische Schicht lassen sich beispielsweise Schichten aus Oxid oder Nitrid verwenden, die während des Herstellungsprozesses von weiteren Bauelementen erzeugt werden. Ferner läßt sich als zweite Kondensatorplatte sowohl eine weitere Slizidschicht, als auch eine Metallisierungslage oder eine dotierte Polysiliziumschicht verwenden. Ferner ist es vorteilhaft, vor dem Zusammenfügen, die Silizidschicht tief in die Oberflächenschicht, beispielsweise mit einer Grabenätzung, einzubringen, um die Silizidschicht nach dem Zusammenfügen in der Nähe der Oberfläche zu legen.

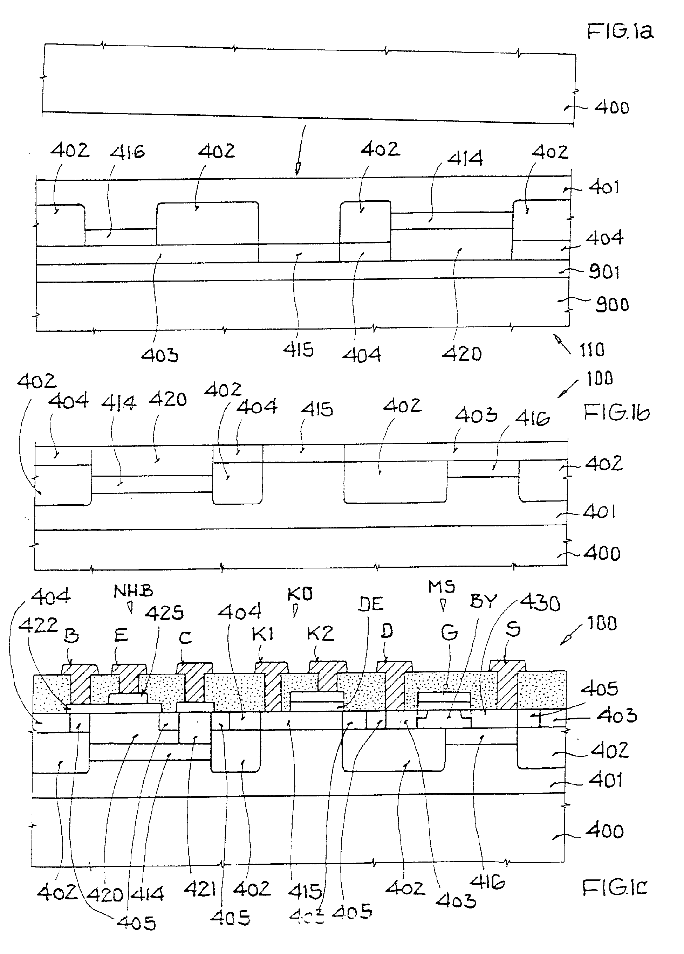

In einer anderen Weiterbildung des Verfahrens ist es zur Erzeugung komplexer integrierter Schaltungen vorteilhaft, MOS-Transistoren gemeinsam mit Bipolar-Transistoren, insbesondere HBT-Transistoren, auf einem Wafer herzustellen und die einzelnen Bauelemente mittels einer Grabenisolierung voneinander elektrisch zu isolieren. Da die erzeugten Boxen isoliert sind, lassen sich die in den Boxen liegenden Bauelemente auf unterschiedlichem elektrischen Potential betreiben. Die Grabenätzung wird vorzugsweise mittels eines Trenchprozesses durchgeführt, der eine gute Selektivität zu der isolierenden Zwischenschicht aufweist. Da keine ganzflächige Silizidschicht vorliegt, läßt sich ein kostengünstiger und einfacher Trenchprozeß verwenden. Ein weiterer Vorteil ist, daß keine Metallionen während der Trenchätzung freigesetzt werden, d.h. für das Vergraben der Schichten lassen sich besonders hochtemperaturfeste Silizide erzeugen, deren Metallionen, wie beispielsweise Kobalt oder Nickel, in geringsten Spuren sehr schädliche Verunreinigungen bei den Bauelementen verursachen.
Das erfindungsgemäße Verfahren soll nachfolgend anhand eines Ausführungsbeispiels im Zusammenhang mit einer Zeichnungsfolge erläutert werden. Es zeigen die
- Fig. 1a- c: einen schematisierten Ablauf eines Herstellungsprozesses der mehrere Gattungen von Halbleiterbauelementen auf einem Silizium-Wafer, der eine isolierende Zwischenschicht und vergrabene silizidierte Bereiche aufweist, erzeugt.

Die in Figur 1a-c dargestellte Folge von Prozeßschritten zeigt einen Herstellungsprozess mittels dem mehrere Gattungen von Halbleiterbauelementen gemeinsam auf einem Wafer 100 mit isolierender Zwischenschicht aus Siliziumoxid (SOI-Wafer), der vergrabene silizidierte Bereiche aufweist, hergestellt werden. Dabei isoliert die ganzflächige Zwischenschicht die Oberflächenschicht, die als monokristalline Siliziumschicht ausgebildet ist, elektrisch von dem Trägermaterial. Derartige SOI-Wafer werden beispielsweise als Ausgangsmaterial für die Herstellung von substratstromfreien integrierten Schaltungen verwendet. Im Folgenden wird der Herstellungsprozeß näher erläutert.

Die Figur 1a zeigt einen Querschnitt eines ersten SOI-Wafers 110 und eines zweiten Silizium-Wafers 400, wobei die Oberfläche des ersten SOI-Wafers 110, die aus einer Oxidschicht 401 besteht, mit der Silizium-Oberfläche des zweiten Wafers 400 zusammengefügt wird. Ferner weist der erste SOI-Wafer 110 einen Träger 900 aus Silizium auf, an den sich eine Oxidschicht 901 als isolierende Schicht, deren Dicke vorzugsweise zwischen 0.1 µm und 2.0 µm liegt, anschließt. An die Oxidschicht 901 schließen sich mehrere Bereiche aus Silizium 403, 404 und 420 an. Ausgangspunkt für die Strukturierung, deren Prozessfolge nicht abgebildet ist, ist eine ganzflächige Siliziumschicht, die der Dicke des Bereiches 420 entspricht und vorzugsweise 0.6 µm beträgt. In einem nachfolgenden Prozessschritt wird der Bereich 420 mit einer Konzentration von 10e17 cm3 n-dotiert. Mittels einer anschließenden LOCOS-Oxidation werden die Schichtdicken der Siliziumbereiche 403 und 404 eingestellt, wobei durch die Strukturierung des LOCOS-Oxides die Oxid-Bereiche 402 erzeugt werden. In einem nachfolgenden Prozessschritt werden in den Bereichen 414, 415 und 416 eine Silizidschicht erzeugt, wobei zuvor im Bereich 415 mittels einer Grabenätzung die Silizium-Schicht gedünnt wird. In einem nachfolgenden Prozeßschritt wird die Oxidschicht 401, mittels einer Abscheidung aufgebracht und mittels eines CMP-Prozesses planarisiert, um anschließend die Oberfläche des ersten Wafers 110 mit der Oberfläche des Wafers 401 zusammenzufügen und den weiteren SOI-Wafer 100 zu erzeugen.

In Figur 1b ist der Querschnitt des zusammengefügten SOI-Wafers 100 dargestellt, wobei der Träger 900 und die Oxidschicht 901 des ersten SOI-Wafers 110 vorzugsweise in einer Kombination aus einem chemisch-mechanischen Polierschritt und einem nasschemischen Ätzschritt entfernt wurde und der naßchemische Prozeßschritt für die Ätzung des Trägers eine Selektivität in der Ätzrate zwischen Silizium und Oxid aufweist.

In Figur 1c ist der Querschnitt des zusammengefügten SOI-Wafers 100 dargestellt, wobei durch eine Abfolge von weiteren Prozessschritten, die im einzelnen nicht abgebildet sind, drei unterschiedliche Gattungen von Bauelementen, ein NPN-HBT NHB über dem silizidierten Bereich 414, ein Kondensator KO mittels des silizidierten Bereichs 415 und ein MOS-Transistor MS mittels des silizidierten Bereichs 416, hergestellt werden. Zur Herstellung des NPN-HBTs NHB wird in dem n-dotierten Bereich 420 eine Kollektoranschluß Zone 421, die eine hohe n-Dotierung aufweist, eingebracht, um den silizidierten Bereich 414, der als Kollektoranschlusschicht des NPN-HBT NHB dient, niederohmig anzuschließen. Anschließend wird mittels einer Grabenisolation, vorzugsweise eines sogenannten STI Prozesses, in der obersten Siliziumschicht 403 und 404 mehrere Isolationsgräben 405 erzeugt, um einzelne Silizium-Boxen, für die zu erzeugenden Bauelemente, herzustellen. Anschließend wird die Basis- und Emitterschicht des NPN-HBTs NBH mittels eines mehrstufigen Epitaxieprozesses erzeugt. Während der Herstellung des NPN-HBTs NHB werden die Bereiche des MOS-Transistors MS mittels einer Oxidschicht geschützt. Nach der Herstellung des HBT-Transistors NHB wird der MOS-Transistor MS über dem silizidierten Bereich 416 erzeugt, wobei die Justierung der Transistorbereiche und die Source- und Drainimplantationen so gewählt werden, daß ein "fully depleted" MOS-Transistor MS entsteht, dessen Body-Bereich BY mit der Source-Bereich mittels des silizidierten Bereichs 416 kurzgeschlossen wird. Ausgehend von dem silizidierten Bereich 415, der die erste Platte K1 eines Kondensators KO bildet, wird durch die Verwendung der Herstellungsschritte des NPN-HBTs NHB und des MOS-Transistors MS die Fertigstellung des Kondensators KO gemeinsam durchgeführt, wobei als Dielektrikum DE die Schutzschicht des MOS-Gebietes und als zweite Platte K2 des Kondensators KO die Gateanschlußschicht des MOS-Transistors MS verwendet wird.

Der Vorteil des dargestellten Ablaufs besteht in der Strukturierung des ersten SOI-Wafers 110 vor dem Zusammenfügen der Oberfläche mit einem weiteren Wafer 400. Hierbei lässt sich mittels der Erzeugung von unterschiedliche Siliziumdicken und der Herstellung von silizidierten Bereichen, die in unterschiedlichen Tiefen liegen, eine optimale Anpassung der einzelnen Bauelementboxen an die unterschiedlichen elektrischen Parameter der jeweiligen Bauelementgattungen vornehmen. Da die wesentlichen Prozessschritte vor dem Zusammenfügen erfolgen, weist der entstehende SOI-Wafer 100 eine plane und defektfreie Oberfläche auf. Insbesondere für die Integration von Höchstfrequenz-Transistoren wird mit dem neuen Verfahren eine einfache Integration von MOS- und bipolar Transistoren ermöglicht, wobei mittels den vergrabenen Silizidschichten sich die jeweiligen HF-Eigenschaften weiter verbessern lassen. Ferner lässt sich bereichsweise, wie beispielsweise unter HF-Bondpads, die Dicke der isolierenden Zwischenschicht zur besseren Entkopplung wesentlich erhöhen. Ferner lässt sich das Verfahren zum Vergraben von silizidierten Bereichen auch auf Wafer ohne isolierende Zwischenschicht übertragen.

## Patentansprüche

1. Verfahren zur Herstellung von Bauelementen auf einem Silizium-Wafer (100), aus einem ersten aus einer auf einem Träger (900) angeordneten isolierenden Zwischenschicht (901) und einer daran anschließenden Oberflächenschicht bestehenden Silizium-Wafer (110), und einem zweiten eine Oberfläche aufweisenden Silizium-Wafer (400), indem die beiden Wafer (110, 400) über die jeweiligen Oberfläche mittels eines sogenannten Wafer-Bonding zusammengefügt werden,
**dadurch gekennzeichnet, daß**
• vor dem Zusammenfügen auf dem ersten Silizium-Wafers (100) innerhalb oder auf Oberfläche der Oberflächenschicht wenigstens ein silizidierter Bereich (414, 415, 416) erzeugt wird, und
• anschließend auf der Oberfläche wenigstens eines Silizium-Wafers (110, 400) wenigstens eine isolierende Schicht aufgebracht wird, und
• nach dem Zusammenfügen der Träger (900) und wenigstens ein Teil der isolierenden Schicht (901) des ersten Silizium-Wafers (110) entfernt wird, und
• anschließend in einer Abfolge von mehreren Prozessschritten wenigstens ein Bauelement (NHB, KO, MS) in der Oberflächenschicht des Silizium-Wafers (100) hergestellt wird.

2. Verfahren nach Anspruch 1, **dadurch gekennzeichnet, daß** die Dicke der Oberflächenschicht des ersten Silizium-Wafers (110) kleiner als 1.0 µm ist.

3. Verfahren nach Anspruch 1, **dadurch gekennzeichnet, daß** die isolierenden Schicht nur auf die Oberfläche des ersten Silizium-Wafers (110) aufgebracht wird und vorzugsweise aus Siliziumdioxid (401) eine Dicke größer als 0.2 µm aufweist.

4. Verfahren nach einem der Ansprüche 1 oder 2, **dadurch gekennzeichnet, daß** in vorgegebenen Gebieten die Dicke der Oberflächenschicht vorzugsweise durch ein thermisches Oxid (Locos) (402) reduziert wird.

5. Verfahren nach einem der Ansprüche 1 oder 2, **dadurch gekennzeichnet, daß** in vorgegebenen Gebieten die Dicke der Oberflächenschicht vorzugsweise durch eine selektive Epitaxie erhöht wird.

6. Verfahren nach einem der Ansprüche 1 bis 5, **dadurch gekennzeichnet, daß** als Bauelement ein MOS-Transistor (MS) erzeugt wird.

7. Verfahren nach Anspruch 6, **dadurch gekennzeichnet, daß** die Source und Drain Zonen des MOS-Transistors (MS) die Oberflächenschicht des Silizium-Wafers (100) vollständig durchdringen.

8. Verfahren nach Anspruch 6 oder 7, **dadurch gekennzeichnet, daß** der Source und Body-Bereich (BY) des MOS-Transistors (MS) von einem vergrabenen Silizidbereich (416) kurzgeschlossen wird.

9. Verfahren nach einem der Ansprüche 1 bis 5, **dadurch gekennzeichnet, daß** als Bauelement ein bipolarer Transistor erzeugt wird.

10. Verfahren nach Anspruch 9, **dadurch gekennzeichnet, daß** in einem silizidierten Bereich (414) ein vertikaler Transistor erzeugt wird und der silizidierte Bereich (414) als Kollektoranschlussschicht dient.

11. Verfahren nach einem der Ansprüche 9 oder 10, **dadurch gekennzeichnet, daß** als Halbleiterbauelement ein vertikaler Heterobipolartransistor (NHB) erzeugt wird.

12. Verfahren nach einem der Ansprüche 1 bis 5, **dadurch gekennzeichnet, daß** als Halbleiterbauelement ein Kondensator (KO) erzeugt wird.

13. Verfahren nach Anspruch 12, **dadurch gekennzeichnet, daß** der Kondensator (KO) in einem silizidierten Bereich (415) erzeugt wird und der silizidierte Bereich (415) als eine Platte des Kondensators (KO) dient.

14. Verfahren nach einem der Ansprüche 1 bis 13, **dadurch gekennzeichnet, daß** mehrere Halbleiterbauelemente (NHB, MS, KO) erzeugt werden und die Halbleiterbauelemente (NHB, MS, KO) lateral durch eine Grabenisolierung getrennt werden.
